(19) Europäisches Patentamt

European Patent Office

Office européen des brevets

(11) **EP 1 473 385 A1**

(12) **EUROPEAN PATENT APPLICATION**

(43) Date of publication:
**03.11.2004 Bulletin 2004/45**

(51) Int Cl.7: **C23C 28/04**, C23C 14/02

(21) Application number: **04252384.5**

(22) Date of filing: **23.04.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (72) Inventors:<br>• **Imamura, Shinya**<br>  **Itami-shi Hyogo (JP)**<br>• **Moriguchi, Hideki**<br>  **Itami-shi Hyogo (JP)**<br>• **Murakami, Daisuke**<br>  **Itami-shi Hyogo (JP)** |
| (30) Priority: **30.04.2003 JP 2003125546**<br>**24.02.2004 JP 2004048382** | (74) Representative:<br>**Cross, Rupert Edward Blount et al**<br>**BOULT WADE TENNANT,**<br>**Verulam Gardens** |
| (71) Applicant: **SUMITOMO ELECTRIC INDUSTRIES, Ltd**<br>**Osaka-shi, Osaka 541-0041 (JP)** | **70 Gray's Inn Road**<br>**London WC1X 8BT (GB)** |

(54) **Coated cutting tool**

(57) The present invention's cutting tool coated using the PVD process can cut with high geometrical precision, produce a good machined surface, and cut for a prolonged time. Its substrate (1) is composed of cemented carbide or cermet, has a surface roughness, Ra, of at most 0.3 μm, is structured by hard particles having an average particle diameter of 0.3 to 1.5 μm, and has a cutting part having a sharp positive edge. Its coating (2) is formed over the substrate using the PVD process and comprises an inner layer (2b) and an outer layer (2a). The total thickness of the inner and outer layers is at most 2.0 μm. The inner layer comprises (a) at least one of the 4a-, 5a-, 6a-group elements, Al, and Si and (b) at least one of carbon, nitrogen, and oxygen. The outer layer comprises (c) at least one of boron, silicon, carbon, and nitrogen and (d) Ti.

FIG. 1

EP 1 473 385 A1

**Description**

The present invention relates to a cutting tool coated using the physical vapor deposition (PVD) process that has excellent sharpness and can produce a product having a good machined surface and high geometrical precision, and particularly to a cutting tool coated using the PVD process to be used in a machining field that requires high precision, such as electronics parts.

Generally, the turning work for parts such as electronics parts, clock parts, and camera parts requires high precision in geometrical precision and in the surface roughness of a machined surface. In addition, the recent miniaturization of electronics and other devices has been requiring higher precision in geometrical precision and surface roughness for their parts. As the cutting tool for such high-precision parts, an indexable insert coated with TiAlN, TiCN, or a similar material has widely been used. An ordinary coated indexable insert is covered with a coating having a thickness of 3 to 5 $\mu$m or so. In the cutting of high-precision parts, the amount of feed and the depth of cut are small in many cases. This condition tends to cause the coating to suffer chipping. Once the chipping develops, the tool cannot be used anymore in many cases because the surface roughness increases or the amount of tool correction increases. Therefore, an ordinary coated indexable insert cannot be used reliably as the cutting tool for the high-precision machining.

To solve the above-described problem, published Japanese patent application *Tokukai* 2001-277004 has disclosed a method in which a substrate having a small magnitude of surface roughness is covered with a TiCN-based coating having a thickness of at most 2 $\mu$m. This method is intended to produce a stable built-up edge at the time of cutting so that it can protect the cutting edge to stabilize the machined dimension. There is another problem. When a sharp edge is covered with a highly hard TiAlN-based-coating, a high remaining compressional stress in the coating tends to spall the coating. As a result, the coating suffer spalling even with a slight shock. To solve this problem, published Japanese patent application *Tokukai* 2002-160108 has disclosed a method in which a TiAlN-based-coating is stably formed over a cutting edge by providing it with a round-type honing or a chamfered corner each having a width of 0.1 to 20 $\mu$m.

However, in the method of protecting the cutting edge with a built-up edge by forming a TiCN-based coating having a thickness of at most 2 $\mu$m to prevent the coating from chipping, the use of the built-up edge may cause the tool to chip when the built-up edge falls off. In addition, because the TiCN-based coating has a lower hardness than that of a coating such as a TiAlN-based-coating, it would wear away in the early stage, exposing the substrate. As a result, the built-up edge grows more than necessary to reduce the dimensional precision and cause other problems. On the other hand, when the cutting edge is provided with a round-type honing or a chamfered corner to prevent the spalling of the TiAlN-based-coating, the cutting resistance would increase. This increase tends to cause the work material to weld, making the machined surface whitish and increasing the surface roughness and dimensional variations.

An object of the present invention is to offer a cutting tool coated using the PVD process that can produce a product having high geometrical precision and a good machined surface and can continue the cutting work for a prolonged time.

The present invention achieves the foregoing object by offering the following cutting tool coated using the PVD process. The cutting tool comprises:

(a) a substrate that:

(a1) is composed of cemented carbide or cermet;
(a2) has a surface roughness, Ra, of at most 0.3 $\mu$m (the term "Ra" means a center-line average height);
(a3) is structured by hard particles having an average particle diameter of 0.3 to 1.5 $\mu$m; and
(a4) has a cutting part having a sharp edge with a positive shape; and

(b) a coating that:

(b1) is formed over the substrate using the PVD process; and
(b2) comprises an inner layer and an outer layer.

The total thickness of the inner and outer layers is at most 2.0 $\mu$m. The inner layer comprises:
(c) at least one member selected from the group consisting of the 4a-group elements, the 5a-group elements, the 6a-group elements, Al, and Si; and
(d) at least one member selected from the group consisting of carbon, nitrogen, and oxygen.

The outer layer comprises (e) at least one member selected from the group consisting of boron, silicon, carbon, and nitrogen; and (f) Ti.

Having these features, the present invention's cutting tool coated using the PVD process is suitable as a tool for precise machining.

According to one aspect of the present invention, the coating may have the following features:

(a) the inner layer has a hardness higher than that of the outer layer;
(b) the inner layer is thicker than the outer layer;
(c) the total thickness of the inner and outer layers is 0.5 to 1.5 µm; and
(d) the outer layer comprises TiN.

As another aspect, the coating may further comprise an undermost layer that:

(a) is formed at the interface with the substrate;
(b) has a thickness of at most 0.5 µm; and
(c) comprises TiN or CrN.

As yet another aspect, the coating may have a remaining compressional stress of -3.0 to 0 GPa. As yet another aspect, the coating may have at its surface portion macroparticles with a density of at most 10 particles per square millimeter, where only the particles having a diameter of at least 5 µm are counted.

According to yet another aspect of the present invention, the substrate may be composed of cemented carbide containing 3 to 12 wt. % Co and having a Vickers hardness of 14 to 22 GPa. As yet another aspect, the substrate may be composed of cermet containing 5 to 12 wt. % Co and having a Vickers hardness of 14 to 22 GPa.

The present invention's cutting tool coated using the PVD process is suitable as an indexable insert for turning work, such as an indexable insert for inside-diameter turning work, and useful as a tool for machining hard disk-related parts.

The present invention's cutting tool coated using the PVD process can produce a product having small dimensional variations and high precision with a good machined surface free from a whitish portion and can continue the cutting work for a prolonged time. Therefore, the cutting tool is useful as a tool for precise machining and, particularly, can be used for the turning work of parts such as electronics parts, clock parts, and camera parts, which require high precision of the order of micrometer.

In the drawing:

Figure 1 is an enlarged cross section showing the structure in the surface portion of the present invention's cutting tool coated using the PVD process.

Figure 2 is a perspective view showing an indexable insert having the structure of the present invention's cutting tool coated using the PVD process.

Figure 3 is a perspective view showing an indexable insert for inside-diameter turning work, the insert having the structure of the present invention's cutting tool coated using the PVD process.

Figure 4 is a cross section showing the cutting part at the time when the bottom face of the cutting part is held horizontally.

Figure 5 is a cross section schematically showing the process of the growth of the macroparticles.

Figure 6 is a diagram schematically showing a cross section of the substrate photographed under a scanning electron microscope (SEM).

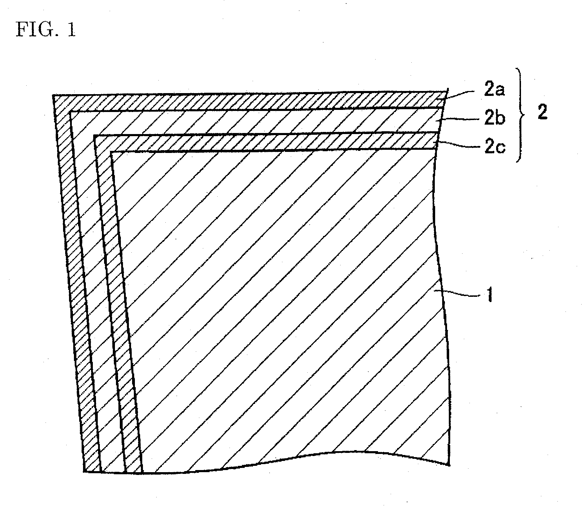

As shown in Fig. 1, the present invention's cutting tool coated using the PVD process comprises a substrate 1 composed of cemented carbide or cermet and a coating 2 formed over the substrate 1 using the PVD process. The coating 2 comprises an outer layer 2a and an inner layer 2b. The total thickness of the inner and outer layers is at most 2.0 µm. The inner layer comprises (a) at least one member selected from the group consisting of the 4a-group elements, the 5a-group elements, the 6a-group elements, Al, and Si and (b) at least one member selected from the group consisting of carbon, nitrogen, and oxygen. The outer layer comprises (a) at least one member selected from the group consisting of boron, silicon, carbon, and nitrogen and (b) Ti. The substrate has a a surface roughness, Ra, of at most 0.3 µm. The substrate is structured by hard particles having an average particle diameter of 0.3 to 1.5 µm. The cutting part has a sharp edge with a positive shape.

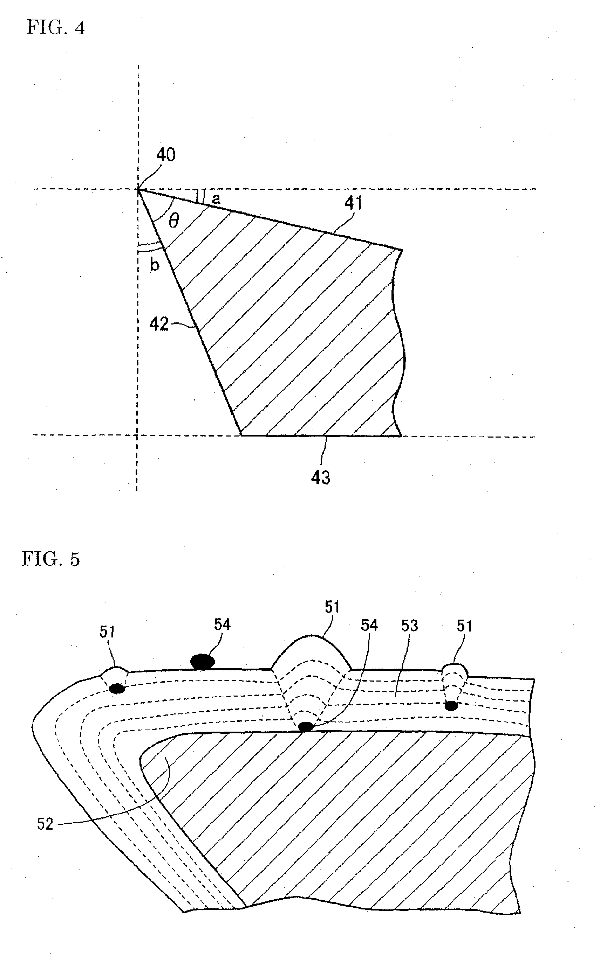

Figure 4 shows a cross section showing a portion in the vicinity of a cutting edge 40 at the time when a bottom face 43 of the cutting part is held horizontally. As can be seen from Fig. 4, the term "positive shape" means that the wedge angle θ of the cutting edge 40 is less than 90 degrees. In particular, it is desirable that the cutting part have a rake face 41 whose rake angle "a" is at least 0 degree, a frank 42 whose clearance angle "b" is at least 5 degrees, and a wedge angle, θ, of at most 80 degrees. In the above description, the term "sharp edge" is used to mean an extremely sharp shape of the cutting part having a cutting edge with a radius of at most 0.01 mm. However, the "sharp edge" also includes the shape of a cutting part in which breakage or chipping is developed when the rake face 41 and the frank 42 are polished.

Because the present invention's cutting tool coated using the PVD process has the above-described features, it has excellent anti-chipping property, wear resistance, and geometrical precision. It also is superior in having a small magnitude of surface roughness of the machined surface. Consequently, it can be used suitably as a cutting tool for precise machining.

To form a coating without spalling even when the substrate has a cutting part having a sharp edge with a positive shape, it is desirable that the total thickness of the inner and outer layers be at most 2.0 $\mu$m, more desirably at most 1.5 $\mu$m. On the other hand, to obtain a good machined surface and excellent geometrical precision, it is desirable that the total thickness of the inner and outer layers be at least 0.5 $\mu$m. In the coating, the outer layer is required to wear normally at the early stage of the cutting in order to suppress the abnormal chipping of the coating so that the increase in the surface roughness and in the amount of tool correction can be suppressed. To meet this requirement, it is desirable that the coating have an inner layer thicker than the outer layer. More specifically, it is desirable that the inner layer be thicker than the outer layer by 0.1 to 0.8 $\mu$m.

To meet the above-described requirement of the normal wearing of the outer layer in the early stage, it is also desirable that the coating have an inner layer having a hardness higher than that of the outer layer. The inner layer having high hardness increases the wear resistance, exercising the effect of increasing the tool life significantly. More specifically, it is desirable that the inner layer have a hardness about 1.05 to about 2 times that of the outer layer, more desirably 1.1 to 1.5 times. To meet this requirement, it is desirable that the outer layer be composed of TiN, for example.

The coating is formed using the PVD process. The PVD process produces remaining compressional stress in the coating. Consequently, even when the substrate has the sharp-edge shape, a good cutting performance can be achieved without reducing the strength of the cutting edge. As the PVD process, the arc ion-plating method is employed suitably, for example. It is desirable the remaining compressional stress in the coating be controlled to fall in the range of -3.0 to 0 GPa to achieve good bonding strength without the self-destruction of the coating, more desirably in the range of -2.8 to -0.5 GPa. In addition, to increase the bonding strength of the coating, it is desirable that as shown in Fig. 1, the coating 2 be provided with an undermost layer 2c at the interface with the substrate 1. In this case, it is desirable that the undermost layer 2c comprise TiN or CrN and have a thickness of at most 0.5 $\mu$m, more desirably at most 0.3 $\mu$m.

The coating formed using the arc ion-plating method has hard particles known as macroparticles at its surface portion. As the macroparticles reduce their size and density, the cutting resistance is reduced, enabling the prevention of the welding of the work material. As a result, the tool life is increased, and the machined-surface quality of the work material is improved. It is desirable that the macroparticles have a density of at most 10 particles per square millimeter, where only the particles having a diameter of at least 5 $\mu$m are counted. If it is more than 10 particles per square millimeter, the work material would weld to the macroparticles, increasing the cutting resistance. As a result, the tool life is deceased, and the machined-surface quality of the work material is degraded, which must be prevented.

The density of the macroparticles can be measured by the observation under a scanning electron microscope (SEM). First, the surface of the specimen is photographed with a magnification of at least 1,000X. Then, the density can be obtained by counting the number of macroparticles on the photograph.

Figure 5 schematically shows the process of the growth of macroparticles 51 by using a cross section of the coating. During the process of forming a coating 53 over a cutting part 52 of a tool, molten particles flying from the target adhere to the surface of the coating to form deposited particles 54. Observation of the surface of the coating under an SEM can confirm the presence of round deposited particles having different diameters. However, these deposited particles are undesirable in the present invention. The flying deposited particles 54 adhere during the growing process of the coating. Therefore, it is likely that as shown in Fig. 5, the deposited particles 54 lie at various thicknesswise positions in the coating 53.

The cutting tool of the present invention has a substrate composed of cemented carbide or cermet. The composition of the cemented carbide or cermet is not specifically limited. The cemented carbide may be either K-type cemented carbide (WC-Co-based one) or P-type cemented carbide (WC-$\beta$-Co-based one). The cermet may be TiC-Ni-Mo$_2$C-based cermet, for example. To decrease the welding of the work material and to increase the machining precision, it is desirable that the substrate have a surface roughness, Ra, of at most 0.3 $\mu$m, more desirably at most 0.2 $\mu$m. The hard particles structuring the substrate are fine particles because they can prevent the increase in the machined-surface roughness due to the falling-off of the particles and facilitate controlling the surface roughness Ra to at most 0.3 $\mu$m. More specifically, it is desirable that the hard particles have an average particle diameter of 0.3 to 1.5 $\mu$m, more desirably 0.5 to 1.3 $\mu$m.

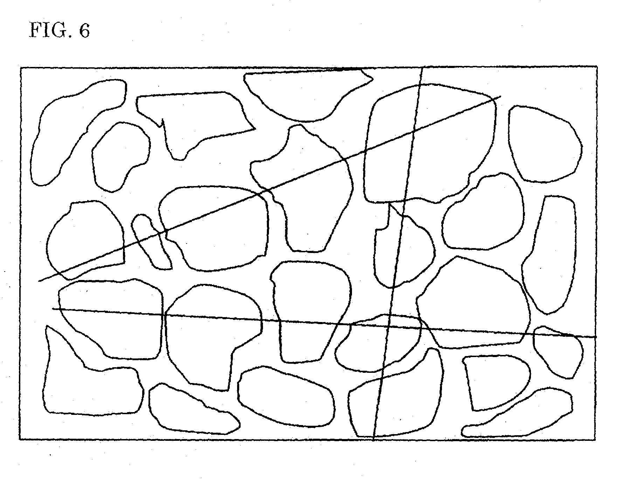

According to the present invention, the average particle diameter of the hard particles is calculated through the following process. First, a cut section of the substrate is treated by lapping to photograph it under an SEM at 10,000 power. Figure 6 schematically shows an example of a cut section of the substrate photographed under an SEM. As shown in Fig. 6, a line is drawn randomly on the photograph. The average particle diameter $d_m$ is calculated by using the following Fullman's equation:

$$d_m = (4/\pi) \cdot (N_L/N_S),$$

where

$N_L$ is the number of hard particles hit by the unit length of the drawn line, and
$N_S$ is the number of hard particles included in the unit area at a randomly sampled location.

When the substrate is composed of cemented carbide, it is desirable that the cemented carbide contain at least 3 wt. % Co to prevent the cemented carbide from becoming brittle, more desirably at least 5 wt. % Co. On the other hand, it is desirable that the cemented carbide contain at most 12 wt. % Co to increase the hardness, more desirably at most 10 wt. % Co. It is desirable that the cemented carbide have high hardness in Vickers hardness to maintain the wear resistance after the substrate is exposed. More specifically, it is desirable that the Vickers hardness be 14 to 22 GPa, more desirably 15 to 22 GPa. Similarly, when the substrate is composed of cermet, it is desirable that the cermet contain at least 5 wt. % Co to prevent the cermet from becoming brittle, more desirably at least 8 wt. % Co. On the other hand, it is desirable that the cermet contain at most 12 wt. % Co to increase the hardness, more desirably at most 10 wt. % Co. It is desirable that the cermet have high hardness in Vickers hardness to maintain the wear resistance after the substrate is exposed. More specifically, it is desirable that the Vickers hardness be 14 to 22 GPa, more desirably 15 to 22 GPa.
When the cutting tool of the present invention comprising the foregoing substrate and coating is used, the surface roughness Ra of the machined surface is reduced to at most 0.15 μm. Consequently, a good machined-surface quality free from a whitish portion can be obtained, and the dimensional variation in the work material is reduced. Therefore, the cutting tool can be used suitably as an indexable insert for turning work, such as an indexable insert for inside-diameter turning work, for example. In particular, it is suitable as a cutting tool for machining hard disk-related parts, which require high-precision machining.

Examples 1 to 12

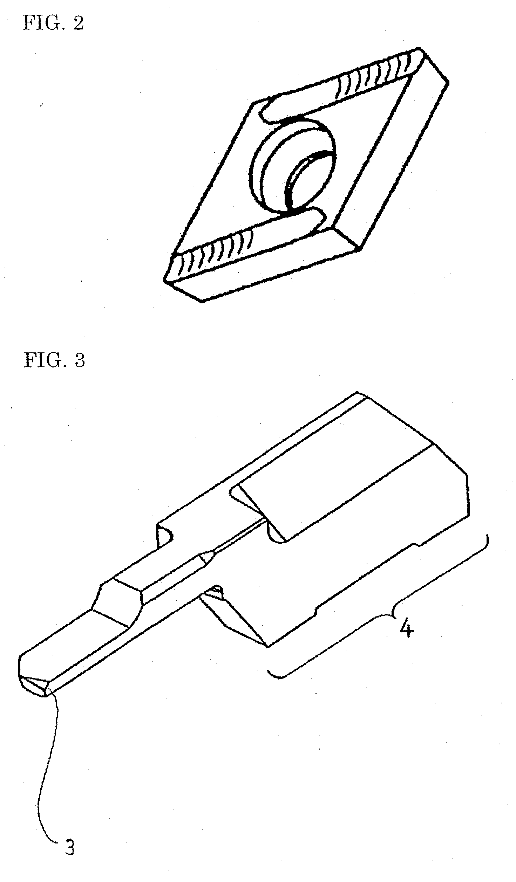

To prove the effect of the present invention, 12 types of samples were produced as Examples 1 to 12. The substrate used for the samples was cemented carbide which had WC having an average particle diameter of 1.0 μm, which had a Co content of 10 wt. %, and which had a Vickers hardness of 15 GPa. By using the substrate, indexable inserts having the shape as shown in Fig. 2 were produced. The indexable insert had a diamond shape with a vertex angle of 55 degrees, had a flank with a clearance angle of 7 degrees, and had a rake face with a rake angle of 20 degrees. To perform high-precision machining, the polished substrate had a cutting part with an incisive sharp edge having a positive shape. The rake face and the flank had a surface roughness, Ra, of 0.2 μm. Various coatings were used as shown in Table I. The coating was formed over the substrate using the arc ion-plating method, which is an ordinary method as the PVD process. The indexable insert was attached to an ordinary holder. Under this condition, outside-diameter turning work was performed to evaluate the cutting performance.

Table I

| Coating | Material | | | Thickness ($\mu$m) | | | | Hardness (Hv) | | Remaining compressional stress (GPa) | Number of deposited particles (number/mm$^2$) |
|---|---|---|---|---|---|---|---|---|---|---|---|
| | Inner layer | Outer layer | Undermost layer | Inner layer | Outer layer | Inner layer + Outer layer | Undermost layer | Inner layer | Outer layer | | |
| Example 1 | TiAlN | TiN | TiN | 0.8 | 0.3 | 1.1 | 0.3 | 2,750 | 2,100 | -1.2 | 1 |
| Example 2 | TiAlN | TiN | Unprovided | 0.8 | 0.3 | 1.1 | 0.0 | 2,750 | 2,100 | -1.0 | 0 |
| Example 3 | TiCrN | TiN | CrN | 0.8 | 0.3 | 1.1 | 0.3 | 2.520 | 2,100 | -1.5 | 3 |
| Example 4 | TiSiN | TiN | TiN | 0.8 | 0.3 | 1.1 | 0.3 | 2,800 | 2,100 | -2.8 | 5 |
| Example 5 | TiAlN | TiCN | TiN | 0.5 | 0.4 | 0.9 | 0.3 | 2,750 | 2,430 | -2.2 | 4 |
| Example 6 | TiAlN | TiBN | TiN | 0.5 | 0.4 | 0.9 | 0.3 | 2,750 | 2,130 | -2.1 | 4 |
| Example 7 | TiAlCNO | TiN | TiN | 0.5 | 0.4 | 0.9 | 0.3 | 2,680 | 2,100 | -1.8 | 6 |
| Example 8 | TiAlN | TiBCN | TiN | 1.0 | 0.4 | 1.4 | 0.3 | 2,750 | 2,170 | -1.5 | 6 |
| Example 9 | TiAlCrN | TiN | CrN | 1.0 | 0.4 | 1.4 | 0.3 | 2.720 | 2,100 | -0.7 | 7 |
| Example 10 | TiAlN | TiN | TiN | 0.2 | 0.1 | 0.3 | 0.1 | 2,750 | 2,100 | -1.2 | 1 |
| Example 11 | TiAlN | TiSiCN | TiN | 0.8 | 0.3 | 1.1 | 0.3 | 2,750 | 2,530 | -2.5 | 6 |
| Example 12 | TiAlN | TiSiCN | TiN | 0.5 | 0.4 | 0.9 | 0.3 | 2,750 | 2,530 | -2.0 | 6 |
| Comparative example 1 | TiAlN | Unprovided | Unprovided | 1.5 | 0.0 | 1.5 | 0.0 | 2,750 | — | -1.0 | 1 |
| Comparative example 2 | TiN | Unprovided | Unprovided | 1.5 | 0.0 | 1.5 | 0.0 | 2,100 | — | -0.5 | 1 |
| Comparative example 3 | TiN | TiAlN | Unprovided | 1.5 | 0.6 | 2.1 | 0.0 | 2,100 | 2,750 | -1.2 | 2 |
| Comparative example 4 | TiAlN | TiN | Unprovided | 1.5 | 1.0 | 2.5 | 0.0 | 2,750 | 2,100 | -2.5 | 7 |
| Comparative example 5 | TiAlN | TiCN | TiN | 1.7 | 1.0 | 2.7 | 0.3 | 2,750 | 2,430 | -2.8 | 8 |
| Comparative example 6 | TiAlN | TiCN | TiN | 0.8 | 0.3 | 1.1 | 0.3 | 2,750 | 2,430 | -2.2 | 3 |

EP 1 473 385 A1

The evaluation of the cutting performance was conducted under the following conditions:

Work material: a round bar made of SUS 430F

Diameter: 12 mm
Length: 10 mm

Cutting speed: 50 m/min
Amount of cut: 0.1 mm
Feed speed: 0.05 mm per revolution
Cutting condition: wet condition using a water-immiscible cutting fluid.

The cutting tool of each example cut 1,000 work materials. After the cutting of 10, 100, 500, and 1,000 work materials, the machined-surface quality and the dimensional variation were evaluated. The machined-surface quality was judged by visually observing the machined work material. The evaluation results are shown in Table II, in which "⊚" shows that the surface was particularly good, "○" shows that the surface was good, and "×" shows that the surface became whitish. The dimensional variation was judged by measuring the outside diameter of 10 work materials obtained immediately before the completion of the cutting of 10, 100, 500, and 1,000 work materials. The evaluation results are shown in Table III, in which "⊚" shows that the difference in diameter between the work material having the maximum diameter and the one having the minimum diameter was 5 μm or less, "○" shows that the difference was more than 5 μm but less than 20 μm, and "×" shows that the difference was 20 μm or more.

Table II

| Coating | Machined-surface quality (Number of machined work materials) | | | |
|---|---|---|---|---|
| | 10 | 100 | 500 | 1,000 |
| Example 1 | ⊚ | ⊚ | ⊚ | ⊚ |
| Example 2 | ⊚ | ○ | ○ | ○ |
| Example 3 | ⊚ | ⊚ | ⊚ | ⊚ |
| Example 4 | ⊚ | ⊚ | ⊚ | ○ |
| Example 5 | ⊚ | ⊚ | ○ | ○ |
| Example 6 | ⊚ | ⊚ | ○ | ○ |
| Example 7 | ⊚ | ⊚ | ⊚ | ⊚ |
| Example 8 | ⊚ | ○ | ○ | ○ |
| Example 9 | ⊚ | ○ | ○ | ○ |
| Example 10 | ○ | ○ | ○ | ○ |
| Example 11 | ⊚ | ⊚ | ⊚ | ○ |
| Example 12 | ⊚ | ○ | ○ | ○ |
| Comparative example 1 | × | × | × | × |
| Comparative example 2 | ○ | × | × | × |
| Comparative example 3 | × | × | × | × |
| Comparative example 4 | ○ | ○ | × | × |
| Comparative example 5 | ○ | ○ | × | × |
| Comparative example 6 | × | × | × | × |

Table III

| Coating | Dimensional variation (Number of machined work materials) | | | |
|---|---|---|---|---|
| | 10 | 100 | 500 | 1,000 |
| Example 1 | ◎ | ◎ | ◎ | ◎ |
| Example 2 | ◎ | ○ | ○ | ○ |
| Example 3 | ◎ | ◎ | ◎ | ◎ |
| Example 4 | ◎ | ◎ | ◎ | ○ |
| Example 5 | ◎ | ◎ | ○ | ○ |
| Example 6 | ◎ | ◎ | ○ | ○ |
| Example 7 | ◎ | ◎ | ◎ | ◎ |
| Example 8 | ◎ | ○ | ○ | ○ |
| Example 9 | ◎ | ○ | ○ | ○ |
| Example 10 | ○ | ○ | ○ | ○ |
| Example 11 | ◎ | ◎ | ○ | ○ |
| Example 12 | ◎ | ○ | ○ | ○ |
| Comparative example 1 | × | × | × | × |
| Comparative example 2 | ○ | × | × | × |
| Comparative example 3 | × | × | × | × |
| Comparative example 4 | ○ | ○ | × | × |
| Comparative example 5 | ○ | ○ | × | × |
| Comparative example 6 | × | × | × | × |

As can be seen from the results in Table II, all the samples of Examples 1 to 12 maintained a good machined-surface quality even after the cutting of 1,000 work materials. In particular, of the present invention's cutting tools, samples of Examples 1, 3, and 7 had a particularly good machined-surface quality even after the cutting of 1,000 work materials. Their coating had an inner layer and an outer layer whose total thickness was 0.5 to 1.5 $\mu$m, had an undermost layer composed of either TiN or CrN at the interface with the substrate, and had an outer layer composed of TiN. Similarly, as can be seen from the results in Table III, all the samples of Examples 1 to 12 showed a small dimensional variation even after the cutting of 1,000 work materials. In particular, samples of Examples 1, 3, and 7 had a diameter difference of 5 $\mu$m or less even after the cutting of 1,000 work materials, showing a particularly small dimensional variation.

Comparative examples 1 to 6

Comparative examples had a coating as shown in Table I. Only the indexable insert of Comparative example 6 had a negative shape with a rake angle of 0 degree, a clearance angle of 0 degree, and a wedge angle of 90 degrees. Except for these conditions, the machined-surface quality and the dimensional variation were evaluated by using methods similar to those used for Examples 1 to 12. The evaluation results of the machined-surface quality are also shown in Table II, and those of the dimensional variation are also shown in Table III. As can be seen from the results in Table II, Comparative example 1, which had no outer layer, and Comparative example 3, which had an outer layer composed of TiAlN, developed chipping in the coating and made the machined surface whitish in the early stage of the cutting test. Comparative example 2, which had a coating formed by a single layer composed of TiN, lacked wear resistance. As a result, its coating wore away in the early stage of the cutting test, exposing the cemented carbide and making the machined surface whitish. Comparative examples 4 and 5, which had an inner layer and an outer layer whose total thickness exceeded 2.0 $\mu$m, developed chipping. As a result, the machined surface was already whitish at the time of cutting the 500th work material. Comparative example 6, whose cutting part had a negative shape, had a high cutting resistance. As a result, the machined surface became whitish and the dimensional variation was large in the early stage of the cutting test.

Comparative examples showed a good result in the dimensional variation while the number of cutting work materials was small, as in the case of the machined-surface quality. However, as the number increased, the coating developed chipping and the cemented carbide was exposed, increasing the dimensional variation. This cutting evaluation test proved that the present invention can prevent the substrate from exposing due to wearing while securely maintaining the sharpness of the cutting tool. This feature enables the maintenance of the good machined-surface quality for a long period and decreases the dimensional variation.

Examples 13 to 15

To confirm the effect of the cemented carbide as the substrate on the cutting performance, indexable inserts were produced by using the same procedure as used in Example 1, except for that the cemented carbides as shown in Table IV were used. The produced indexable inserts were subjected to the cutting of 1,000 work materials to evaluate the machined-surface quality and the dimensional variation. The results of the evaluation are also shown in Table IV. The evaluation method is the same as for Example 1.

Table IV

| Substrate (cemented carbide) | Average particle diameter (μm) | Co content (wt%) | Vickers hardness (GPa) | Machined-surface quality (after cutting 1,000 materials.) | Dimensional variation (after cutting 1,000 materials.) |
|---|---|---|---|---|---|
| Example 13 | 0.5 | 5.0 | 21.5 | ◎ | 7.1 |
| Example 14 | 0.8 | 8.0 | 19.2 | ◎ | 5.2 |
| Example 15 | 1.3 | 12.0 | 15.2 | ◎ | 6.2 |
| Comparative example 7 | 2.0 | 1.0 | 25.2 | × | 35.3 |
| Comparative example 8 | 2.0 | 8.0 | 14.3 | × | 45.2 |
| Comparative example 9 | 1.8 | 20.0 | 13.0 | × | 58.1 |

As can be seen from Table IV, in Examples 13 to 15, a beautiful machined surface free from a whitish portion was obtained and the dimensional variation was small.

Comparative examples 7 to 9

Indexable inserts were produced by using the same procedure as used in Example 1, except for that the cemented carbides as shown in Table IV were used. The produced indexable inserts were subjected to the cutting of 1,000 work materials to evaluate the machined-surface quality and the dimensional variation. The results of the evaluation are also shown in Table IV. The evaluation method is the same as for Example 1. In Comparative examples 7 to 9, the cemented carbide as the substrate was structured by hard particles having an average particle diameter of more than 1.5 μm. As a result, the machined-surface quality was poor and the dimensional variation was large.

Examples 16 and 17

To confirm the effect of the cermet as the substrate on the cutting performance, indexable inserts were produced by using the same procedure as used in Example 1, except for that as the cermet, TiCN shown in Table V were used. The produced indexable inserts were subjected to the cutting of 1,000 work materials to evaluate the machined-surface quality and the dimensional variation. The results of the evaluation are also shown in Table V. The evaluation method is the same as for Example 1.

Table V

| Substrate (cermet) | Average particle diameter (μm) | Co content (wt%) | Vickers hardness (GPa) | Machined-surface quality (after cutting 1,000 materials.) | Dimensional variation (after cutting 1,000 materials.) |
|---|---|---|---|---|---|
| Example 16 | 0.5 | 12.0 | 18.3 | ◎ | 7.1 |
| Example 17 | 1.3 | 8.0 | 17.2 | ◎ | 5.2 |
| Comparative example 10 | 2.5 | 25.0 | 12.2 | × | 42.9 |

As can be seen from Table V, in Examples 16 and 17, a beautiful machined surface free from a whitish portion was obtained and the dimensional variation was small.

Comparative example 10

An indexable insert was produced by using the same procedure as used in Example 1, except for that as the cermet as the substrate, TiCN shown in Table V was used. The produced indexable insert was subjected to the cutting of 1,000 work materials to evaluate the machined-surface quality and the dimensional variation. The results of the evaluation are also shown in Table V. The evaluation method is the same as for Example 1. In Comparative example 10, the hard particles had an average particle diameter as large as 2.5 μm; and the substrate had low hardness. As a result, the tool tended to wear in the early stage of the cutting test, the machined-surface quality was poor, and the dimensional variation was large.

In the foregoing Examples and Comparative examples, the cutting evaluation test was conducted by using the outside-diameter turning work. As an additional cutting evaluation test, various cutting tools were subjected to not only outside-diameter turning work but also other turning work. The test proved that the present invention has an effect similar to that described above for the following cutting tools: (a) a cutting toll for outside-diameter- and shoulder-turning work to which the indexable insert as shown in Fig. 2 is attached, (b) a cutting toll for inside-diameter-turning work to which the indexable insert as shown in Fig. 3 is attached, (c) a cutting tool for grooving, (d) a cutting tool for threading, and (e) other cutting tools for turning work in general. In particular, the cutting tool of the present invention exercised its excellent performance in a field that requires highly precise machining, such as hard disk-related parts. In the above description, the indexable insert shown in Fig. 3 comprises a cutting edge 3 at the top and a holding portion 4 that is to be held by a holder to be used as an inside-diameter turning tool.

It is to be understood that the above-described embodiments and examples are illustrative and not restrictive in all respects. The scope of the present invention is shown by the scope of the appended claims, not by the above-described explanation. Accordingly, the present invention is intended to cover all modifications included within the meaning and scope equivalent to the scope of the claims.

## Claims

1. A cutting tool coated using the PVD process, comprising:

   (a) a substrate that:

   (a1) is composed of one material selected from the group consisting of cemented carbide and cermet;
   (a2) has a surface roughness, Ra, of at most 0.3 μm;
   (a3) is structured by hard particles having an average particle diameter of 0.3 to 1.5 μm; and
   (a4) has a cutting part having a sharp edge with a positive shape; and

   (b) a coating that:

   (b1) is formed over the substrate using the PVD process; and
   (b2) comprises an inner layer and an outer layer;

the total thickness of the inner and outer layers being at most 2.0 µm; the inner layer comprising:

(c) at least one member selected from the group consisting of the 4a-group elements, the 5a-group elements, the 6a-group elements, Al, and Si; and

(d) at least one member selected from the group consisting of carbon, nitrogen, and oxygen;

the outer layer comprising:

(e) at least one member selected from the group consisting of boron, silicon, carbon, and nitrogen; and

(f) Ti.

2. A cutting tool coated using the PVD process as defined by claim 1, wherein in the coating, the inner layer has a hardness higher than that of the outer layer.

3. A cutting tool coated using the PVD process as defined by claim 1 or 2, wherein the coating has a structure such that:

(a) the inner layer is thicker than the outer layer; and

(b) the total thickness of the inner and outer layers is 0.5 to 1.5 µm.

4. A cutting tool coated using the PVD process as defined by any one of claims 1 to 3, wherein in the coating, the outer layer comprises TiN.

5. A cutting tool coated using the PVD process as defined by any one of claims 1 to 4, wherein the coating further comprises an undermost layer that:

(a) is formed at the interface with the substrate;

(b) has a thickness of at most 0.5 µm; and

(c) comprises one material selected from the group consisting of TiN and CrN.

6. A cutting tool coated using the PVD process as defined by any one of claims 1 to 5, wherein the coating has a remaining compressional stress of -3.0 to 0 GPa.

7. A cutting tool coated using the PVD process as defined by any one of claims 1 to 6, wherein the coating has at its surface portion macroparticles with a density of at most 10 particles per square millimeter, where only the particles having a diameter of at least 5 µm are counted.

8. A cutting tool coated using the PVD process as defined by any one of claims 1 to 7, wherein:

(a) the substrate is composed of cemented carbide; and

(b) the cemented carbide contains 3 to 12 wt. % Co and has a Vickers hardness of 14 to 22 GPa.

9. A cutting tool coated using the PVD process as defined by any one of claims 1 to 7, wherein:

(a) the substrate is composed of cermet; and

(b) the cermet contains 5 to 12 wt. % Co and has a Vickers hardness of 14 to 22 GPa.

10. A cutting tool coated using the PVD process as defined by any one of claims 1 to 9, the cutting tool being an indexable insert for turning work.

11. A cutting tool coated using the PVD process as defined by any one of claims 1 to 10, the cutting tool being an indexable insert for inside-diameter turning work.

12. A cutting tool coated using the PVD process as defined by any one of claims 1 to 11, the cutting tool being a tool for the precise machining of electronics parts, hard disk-related parts, clock parts, and camera parts.

FIG. 1

FIG. 2

FIG. 3

4

3

FIG. 4

FIG. 5

FIG. 6

## EUROPEAN SEARCH REPORT

**European Patent Office**

**Application Number**

EP 04 25 2384

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | PATENT ABSTRACTS OF JAPAN vol. 0135, no. 55 (M-904), 11 December 1989 (1989-12-11) & JP 1 228704 A (MITSUBISHI METAL CORP), 12 September 1989 (1989-09-12) | 1 | C23C28/04 C23C14/02 |
| A | * abstract * | 2-12 | |
| Y | WO 01/16388 A (SANDVIK AB) 8 March 2001 (2001-03-08) | 1 | |
| A | * page 2, line 30 - page 6, line 10 * | 2-12 | |
| A,D | PATENT ABSTRACTS OF JAPAN vol. 2002, no. 02, 2 April 2002 (2002-04-02) & JP 2001 277004 A (NGK SPARK PLUG CO LTD), 9 October 2001 (2001-10-09) * abstract * | 1-12 | |
| A | EP 0 999 290 A (SHINKO KOBELCO TOOL CO LTD) 10 May 2000 (2000-05-10) * tables 1,4,7,10,13,16,19,24,27,30,33 * | 1-12 | |

| | | | |
|---|---|---|---|
| | | | **TECHNICAL FIELDS SEARCHED (Int.Cl.7)** |
| | | | C23C |

The present search report has been drawn up for all claims

| Place of search | Date of completion of the search | Examiner |
|---|---|---|
| The Hague | 5 August 2004 | Ekhult, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 04 25 2384

This annex lists the patent family members relating to the patent documents cited in the above-mentioned European search report.
The members are as contained in the European Patent Office EDP file on
The European Patent Office is in no way liable for these particulars which are merely given for the purpose of information.

05-08-2004

| Patent document cited in search report | | Publication date | Patent family member(s) | | Publication date |
|---|---|---|---|---|---|
| JP 1228704 | A | 12-09-1989 | NONE | | |
| WO 0116388 | A | 08-03-2001 | AT | 269425 T | 15-07-2004 |
| | | | DE | 60011644 D1 | 22-07-2004 |
| | | | EP | 1218557 A1 | 03-07-2002 |
| | | | JP | 2003508242 T | 04-03-2003 |
| | | | WO | 0116388 A1 | 08-03-2001 |
| | | | US | 6342291 B1 | 29-01-2002 |
| | | | US | 2002051887 A1 | 02-05-2002 |
| JP 2001277004 | A | 09-10-2001 | NONE | | |
| EP 0999290 | A | 10-05-2000 | JP | 2000129423 A | 09-05-2000 |
| | | | JP | 2000129424 A | 09-05-2000 |
| | | | JP | 2000129466 A | 09-05-2000 |
| | | | JP | 2000129463 A | 09-05-2000 |
| | | | JP | 2000129425 A | 09-05-2000 |
| | | | EP | 0999290 A1 | 10-05-2000 |
| | | | JP | 2000199047 A | 18-07-2000 |
| | | | KR | 2000028568 A | 25-05-2000 |
| | | | US | 6296928 B1 | 02-10-2001 |

EPO FORM P0459

For more details about this annex : see Official Journal of the European Patent Office, No. 12/82